# EUROPEAN PATENT SPECIFICATION

(11) **EP 2 940 759 B1**
(45) Date of publication and mention of the grant of the patent: **29.11.2017**
(21) Application number: 13868071.5
(22) Date of filing: 16.09.2013
(51) Int. Cl.: H01M 10/48, H01M 2/02, H01M 10/42, H01M 2/34, H01M 2/10, H02J 7/00

(54) **PROTECTIVE CIRCUIT MODULE, AND BATTERY MODULE COMPRISING SAME**
SCHUTZSCHALTUNGSMODUL UND BATTERIEMODUL DAMIT
MODULE DE CIRCUIT DE PROTECTION ET MODULE DE BATTERIE LE COMPORTANT

(30) Priority: 27.12.2012 KR 20120154548; 17.01.2013 KR 20130005311
(43) Date of publication of application: 04.11.2015
(73) Proprietor: TYCO ELECTRONICS AMP KOREA Co., Ltd., Gyeongsangbuk-do, 38459 (KR)
(72) Inventor: JUNG, Je Yoo, Daegu 706-170 (KR)
(74) Representative: Johnstone, Douglas Ian
(86) International application number: PCT/KR2013/008362
(87) International publication number: WO 2014/104538

(56) References cited:
- JP-A- 2011 135 654
- JP-A- 2012 059 663
- JP-A- 2012 059 663
- JP-A- 2012 174 507
- JP-A- 2012 221 844
- JP-A- 2012 221 844
- KR-A- 20120 108 260
- US-A1- 2003 231 482
- US-A1- 2004 012 396
- US-A1- 2009 253 027
- US-A1- 2010 209 761

## Description

The following description relates to a protection circuit module and a battery module including the same.

A secondary battery module is designed such that a plurality of cells is connected in series or in parallel and outputs predetermined voltage. Here, the performance of each cell affects the performance of a battery module, largely, the performance of a battery pack coupled with the battery module. Thus, voltage or current of each battery cell is to be measured in order to measure the performance of each battery cell. To this end, a sensing module is mounted within the secondary battery module to measure the voltage or the current.

Electrical signals gathered by the sensing module are transferred to a battery management system (BMS) through an external output terminal, and used to measure the performance of each cell. In such a system, a cell is directly connected to the BMS in which cells manage all of the batteries.

An abnormal chemical reaction and an external impact may cause overcurrent and overvoltage in a cell. In this case, the overcurrent and the overvoltage may affect the BMS directly connected to cells, thereby leading to damage the BMS.

JP 2012-221844 discloses a protection circuit module having a substrate. One side of the substrate is covered by a first cover, and the other side of the substrate is covered by a second cover which also accommodates the substrate. The substrate has a connection terminal, a circuit portion and a data connector mounted on it wherein the connection terminal is connected to a temperature sensor.

US 2010/0209761 discloses a protection circuit module similar to that disclosed in JP 2012-221844 but the connection terminal is instead connected to a cell.

US 2004/0012396 discloses a protection circuit module similar to that disclosed in US 2010/0209761 but there is no data connector mounted on the substrate.

To prevent the above situation, there is a need for a method that may protect the entire system from a malfunctioning operation of a battery, such as overcurrent and overvoltage occurring in a battery cell by providing a protection circuit module.

According to the present invention there is provided a protection circuit module configured to protect a battery, the protection circuit module comprising: a substrate; a connection terminal configured to mount on the substrate, and to receive an electrical signal of a cell from a cell lead and/or a sensing module; a circuit portion configured to mount on the substrate; a first cover configured to cover one side of the substrate; a second cover configured to accommodate the substrate, and to cover the other side of the substrate; and a data connector configured to mount on the substrate, characterized in that the circuit portion is configured to connect the cell lead and/or the sensing module and the connection terminal, wherein the circuit portion comprises one of or a combination of at least two of a fuse, a relay, a breaker, and a switch; a data connector inserting slot for mounting the data connector on the substrate is formed on the first cover; and a circuit portion inserting slot for mounting the circuit portion on the substrate is formed on the first cover.

The protection circuit module may include a support portion configured to fixably couple with a battery module frame, and configured to accommodate the second cover. The second cover may be fixably pressed between the first cover and support portion.

Hereinafter, a protection circuit module according to an embodiment and a battery module including the protection circuit module will be described by referring to the accompanying drawings.
FIG. 1 is an exploded perspective view of a protection circuit module according to an embodiment.
FIGS. 2A and 2B are perspective views illustrating a substrate according to an embodiment.
FIG. 3 is a perspective view illustrating a first cover according to an embodiment.
FIGS. 4A and 4B are perspective views illustrating a second cover according to an embodiment.
FIG. 5 is an exploded perspective view of a protection circuit module and a support portion according to an embodiment.
FIGS. 6A and 6B are perspective views illustrating a support portion according to an embodiment.
FIGS. 7A and 7B are perspective views illustrating a state in which a battery module is not assembled.
FIG. 7C is a front view illustrating a state in which a battery module is assembled.
FIGS. 8A and 8B are perspective views illustrating a state in which a protection circuit module and a support portion are coupled according to an embodiment.
FIG. 9 is a perspective illustrating a sensing module.

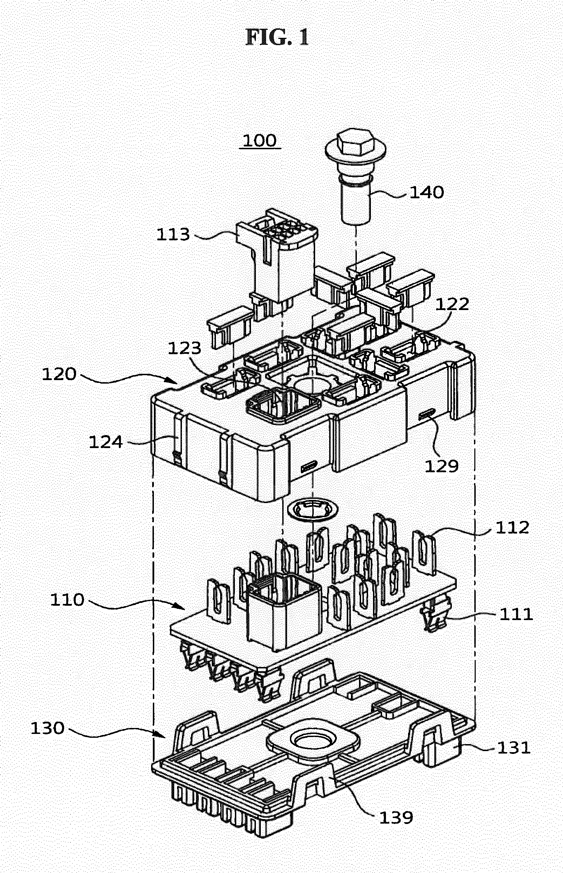

FIG. 1 is an exploded perspective view of a protection circuit module 100 according to an embodiment. Referring to FIG. 1, the protection circuit module 100 may include a substrate 110, a first cover 120, and a second cover 130. Also, a connection terminal 111 and a circuit portion 112 may be mounted on the substrate 110. Hereinafter, for ease of description, the description will be made based on an example in which the circuit portion 112 is a fuse. However, the embodiment is not limited thereto and further various descriptions related thereto are made below.

The substrate 110 is accommodated in the second cover 130, and the first cover 120 covers one surface (a top surface in the present embodiment) of the substrate 110. At the same time, the second cover 130 covers the other surface (a bottom surface in the present embodiment) of the substrate 110. Accordingly, the substrate 100 and primary circuits or parts mounted on the substrate 100 are protected. In addition, the first cover 120 and the second cover 130 may include a coupler for mutual coupling to couple with each other based on the substrate 110.

The connection terminal 111 and the fuse 112 may be directly or indirectly mounted on the substrate 110. For example, as illustrated, the connection terminal 111 may be directly mounted on the substrate 110, and the fuse 112 may be indirectly mounted on the substrate 110 through a fuse terminal to be directly mounted on the substrate 110. Meanwhile, as in the present embodiment, the fuse 112 and the connection terminal 111 may be separately mounted on the substrate 110. In detail, the fuse 112 may be mounted on one surface (the top surface in the present embodiment) of the substrate 110 and the connection terminal 111 may be mounted on the other surface (the bottom surface in the present embodiment) of the substrate 110, however, are not limited thereto. Further, a fuse inserting slot 122 for mounting and replacing the fuse 112 may be formed on the first cover 120, and a connection terminal protecting portion 131 for accommodating the connection terminal 111 and protecting the connection terminal 111 may be formed on the second cover 130, which will be described below.

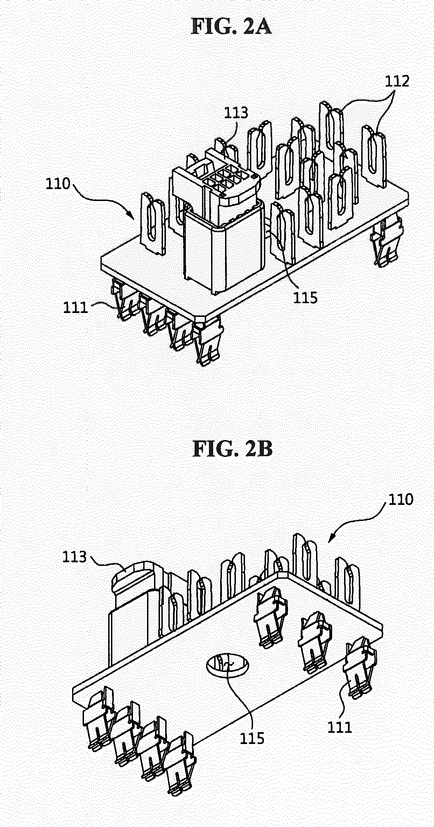

FIGS. 2A and 2B are perspective views illustrating the substrate 110 according to an embodiment. The substrate 110 may be a general printed circuit board (PCB), and the connection terminal 111 and the fuse 112 may be mounted on the substrate 110. As illustrated, the connection terminal 111 and the fuse 112 may be separately mounted on both surfaces of the substrate 110, respectively. However, it is only an example.

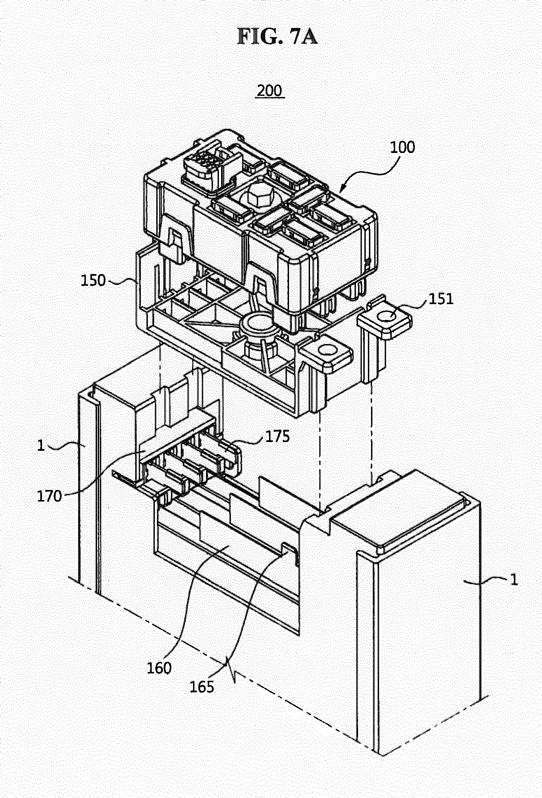

The connection terminal 111 is provided to correspond to a cell lead and/or a sensing module of a battery module, and may receive an electrical signal of each cell from the cell lead and/or the sensing module and may configure a cell signal connector. Also, in correspondence thereto, a cell lead, a sensing module 170, and tabs 165 and 175 to be described below with reference to FIG. 7A may transmit an electrical signal of a cell and thus, may configure a cell signal output portion. A plurality of connection terminals 111 may be provided and in this instance, may be provided in a shape of tongs and thus, may have an elastic force in a facing direction. In addition, a single connection terminal 111 may be divided into a plurality of prongs. When cell leads are formed bi-directionally and in this instance, the number of cells is 2n, n connection terminals 111 may be provided on one side and (n+1) connection terminals 111 may be provided on the other side. FIG. 2B illustrates an example in which 6 cells are provided. Referring to FIG. 2B, three connection terminals 111 may be provided on one side and four connection terminal 111 may be provided on the other side.

The fuse 112 may serve to electrically connect the cell lead and/or the sensing module to the connection terminal 111. Accordingly, when an abnormal phenomenon such as overcurrent and overvoltage occurs in a cell, the fuse 112 may short-circuit the electrical connection and protect an entire system including a battery management system (BMS). The fuse 112 may be provided based on a shape or a size of the substrate 110, and a contact point between the fuse 112 and the connection terminal 111 may not make a one-to-one correspondence. For example, the fuses 112 may be aligned in both a longitudinal direction and a traverse direction on the substrate 110, which differs from the alignment of the connection terminals 111. Further, the fuse 112 may be a fuse widely used for vehicles, for example, a blade-type fuse, a glass tube fuse, a Bosch type fuse, a fusible link, and a fuse limiter, or a semiconductor fuse.

As described above, the fuse 112 is one example of a circuit portion that constitutes a protection circuit module. That is, in addition to a fuse, the circuit portion 112 may be a relay by an electronic device or a circuit breaker such as an earth leakage circuit breaker, an electromagnetic circuit breaker, and a bimetal circuit breaker. Also, the circuit portion 112 may use a switch or a relay using a semiconductor of a metal-oxide semiconductor field effect transistor (MOSFET) and a non-contact switch such as a solid state replay (SSR). In addition, the circuit portion 112 may include a combination of the aforementioned fuse, relay, switch, and circuit-breaker and thereby use the same together.

Dissimilar to the aforementioned examples of protecting an entire battery module by achieving the electrical short-circuit if necessary, the circuit portion 112 may include all of the configurations for achieving the stability of a battery module in a different manner. For example, a voltage stabilization circuit, a voltage signal transceiving circuit, a circuit for switching ON/OFF a connection point of each cell, and a temperature/data emission circuit may constitute the circuit portion 112 and thereby be provided to the substrate 110 or the battery module, thereby protecting the battery module.

The circuit portion 112 may be electrically connected to the cell signal output portion by contacting (for example, contact through a contact point) with the cell signal output portion (for example, the tabs 165 and 175). The contact point is located inside the protection circuit module 100 to prevent the short-circuit of the contact point from occurring due to the external effect, and to maintain the electrical connection between the circuit portion 112 and the cell signal output portion, thereby stably operating the entire system.

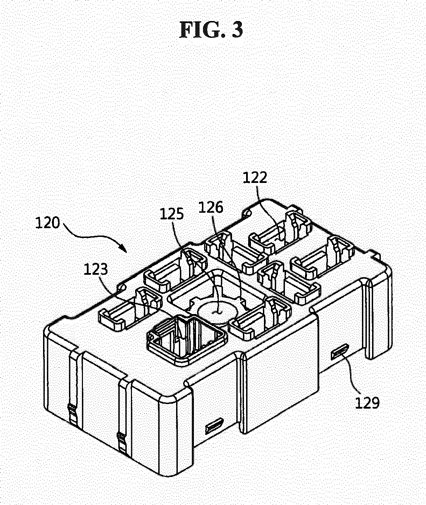

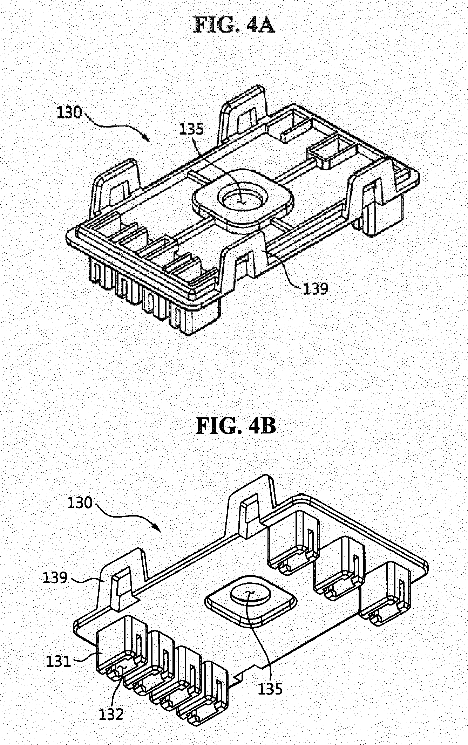

FIG. 3 is a perspective view illustrating the first cover 120 according to an embodiment, and FIGS. 4A and 4B are perspective views illustrating the second cover 130 according to an embodiment. As described above, the first cover 120 may cover one surface of the substrate 110 and the second cover 130 may cover the other surface of the substrate 110, thereby protecting the substrate 110. In such a manner, the first cover 120 and the second cover 130 may configure a single circuit case configured to accommodate the substrate 110 therein. The circuit case may protect the substrate 110 from an outside and may be separable if necessary, thereby enabling each part to be easily repairable or replaceable. Although the present embodiment describes that the first cover 120 and the second cover 130 configure the circuit case, it is only an example and thus, various modifications and changes may be made to the circuit case.

A first slot for an interface with an outside may be formed on a top surface of the circuit case, and a second slot for receiving an electrical signal of a battery module may be formed on a bottom surface of the circuit case. The first slot may be embodied as a circuit portion inserting slot 122 and a data connector inserting slot 123 and the second slot may be embodied as a guide slot 132 and a connection terminal hole 152, which will be described below.

According to the protection circuit module 100 constructed as above, when an abnormal phenomenon such as overcurrent and overvoltage of a cell is detected from the cell lead and/or the sensing module, the protection circuit module 100, particularly, the fuse 112 may protect the entire system including the BMS. Thus, it is possible to minimize the damage to a part even under an abnormal condition and to operate the system without burdening the entire system. In addition, it is possible to exclude an operation such as welding or soldering by modularizing a protection circuit as above. Accordingly, it is possible to further easily assemble the protection circuit to the battery module and to very easily detach the protection circuit from the battery module based on a purpose such as a repair or a replacement.

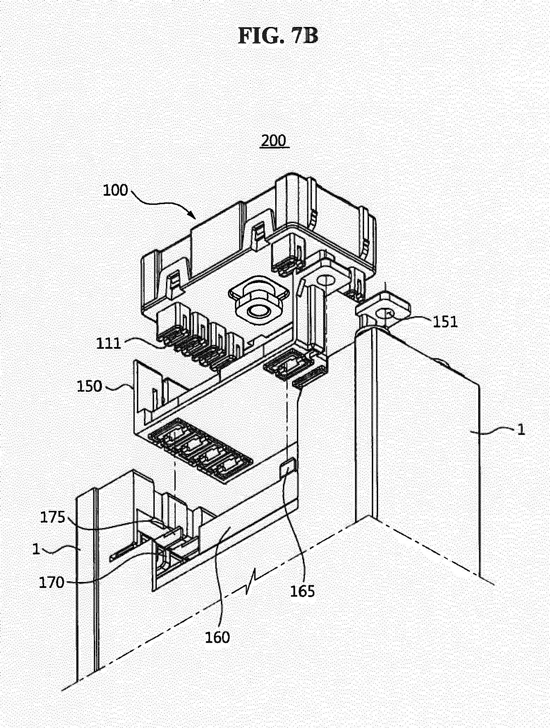

For the firmness of the protection circuit module 100, the first cover 120 and the second cover 130 may include a coupler for mutual coupling and may couple with each other based on the substrate 110. A description related thereto will be made by referring again to FIG. 1. A protrusion 129 may be formed on the first cover 120, and a hook 139 may be formed on the second cover 130 at a location corresponding to a location of the protrusion 129 of the first cover 120. That is, the protrusion 129 may be hooked by a groove formed on the hook 139 and coupled with the hook 139 in a snap-fit manner. A state in which the protrusion 129 and the hook 139 are coupled with each other can be verified from FIGS. 7A and 7B. The first cover 120 and the second cover 130 may couple with each other and thereby protect the substrate 110 therein although the first cover 120 and the second cover 130 are used in a vibrating environment such as a vehicle.

For the similar purpose, the protection circuit module 100 may further include a fixing member 140. The fixing member 140 may be designed to penetrate and thereby couple the first cover 120, the substrate 110, and the second cover 130 at a time. The fixing member 140 may be configured simultaneously together with the coupler of the first cover 120 and the second cover 130, thereby further improving the firmness of the protection circuit module 100. A bolt and a nut may be used for the fixing member 140. However, it is only an example and the embodiment is not limited thereto. When the fixing member 140 penetrates and thereby couples the respective members, only a single fixing member 140 may be provided to penetrate the center of the respective members. When a plurality of fixing members is used at different locations instead of the center of each member, the fastening force may be out of balance. Accordingly, the balance may be maintained and the cell lead and/or the sensing module may be connected with the connection terminal 111 at a time by making the fixing member 140 penetrate the center of and thereby couple the members.

In addition, for the penetration of the fixing member 140, fixing holes 125, 115, and 135 may be formed on the first cover 120, the substrate 110, and the second cover 130, respectively. A plurality of ribs may be provided on at least one of the fixing holes 125, 115, and 135. A description related thereto will be made with reference to FIG. 3. Referring to FIG. 3, a plurality of ribs 126 is formed in a radial form along the periphery of the fixing hole 125 formed on the first cover 120, thereby supporting the fixing member 140. Accordingly, it is possible to prevent the first cover 120 from being damaged due to the fastening force of the fixing member 140. Although the present embodiment describes that the plurality of ribs 126 is provided only to the fixing hole 125 of the first cover 120, it is only an example. Also, a supporting structure using the same method may be applied to the fixing hole 115 of the substrate 110 and the fixing hole 135 of the second cover 130.

Referring again to FIGS. 1, 2A, and 2B, a data connector 113 may be mounted on the substrate 110 to transmit cell information to an external system. Also, the data connector inserting slot 123 for mounting the data connector 113 on the substrate 110 may be formed on the first cover 120 (see FIG. 3). Accordingly, it is possible to easily repair and replace the data connector 113.

For a similar purpose, the fuse inserting slot 122 may be formed on the first cover 120. The fuse 112 may be inserted through the fuse inserting slot 122 and a repair and a replacement may be easily performed by individually separating the fuse 112.

Referring to FIGS. 4A and 4B, the connection terminal protecting portion 131 may be formed on the second cover 130. The connection terminal protecting portion 131 may be designed in a shape corresponding to the connection terminal 111 to accommodate the connection terminal 111, thereby protecting the connection terminal 111 from external impact and dusts. As described above, since the connection terminal 111 is coupled with the cell lead and/or the sensing module and receives an electrical signal of a cell, the guide slot 132 for coupling the connection terminal 111 with the cell lead and/or the sensing module may be formed on one side of the connection terminal protecting portion 131.

Hereinafter, the battery module including the aforementioned protection circuit module 100 will be described. The battery module may include a support portion in addition to the protection circuit module 100.

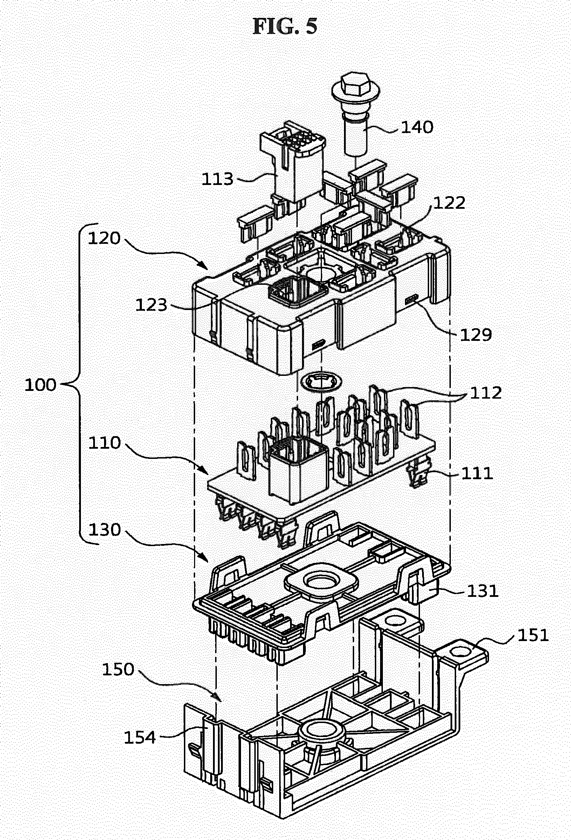

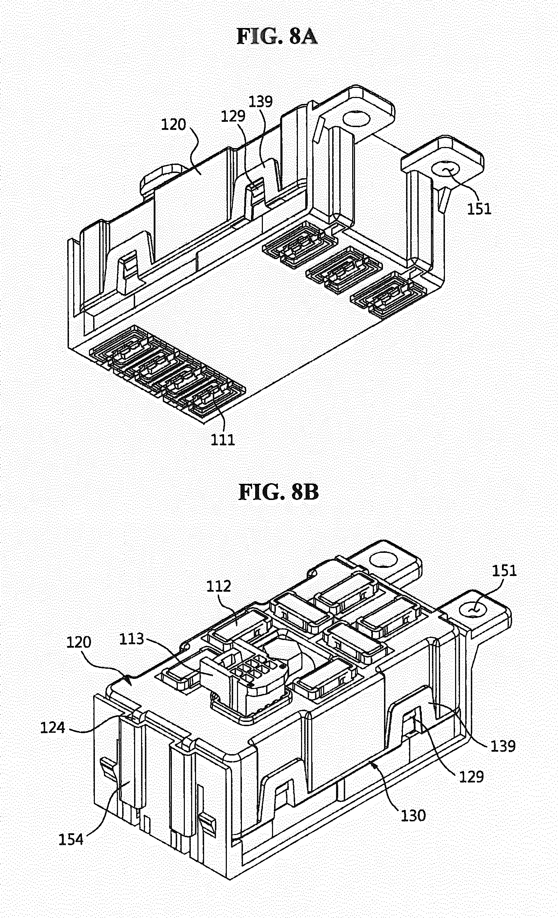

FIG. 5 is an exploded perspective view of the protection circuit module 100 and a support portion 150 according to an embodiment. For ease of description, in FIGS. 5, 6A, 6B, 7A, and 7B, a battery module frame is omitted, and the protection circuit module 100 and the support portion 150 may be configured as a single module. However, without being limited thereto, the protection circuit module 100 may be provided as illustrated in FIGS. 8A and 8B, and the support portion 150 may be separately fixably coupled with a battery module frame 1. A detailed description related thereto will be made below.

Referring to FIG. 5, the protection circuit module 100 may be accommodated in the support portion 150. At the same time, the support portion 150 may be fixably coupled with a battery module frame. That is, the support portion 150 may serve to fix the protection circuit module 100 to the battery module frame. According to the present embodiment, since a fixing hole 151 is formed on the support portion 150, the support portion 150 may be coupled with the battery module frame using a coupling element such as a bolt. In addition, the support portion 150 may be directly coupled at an actual application location in addition to the battery module frame. For example, when the protection circuit module 100 or the battery module is applied to a vehicle, the support portion 150 may be coupled with a box for vehicle within the vehicle.

Meanwhile, the support portion 150 may be designed to surround at least a portion of the second cover 130. For example, a cross section of the support portion 150 may be designed in a curved structure and the support portion 150 may surround the second cover 130 from both sides thereof and may further support the protection circuit module 100. Accordingly, when the protection circuit module 100 is to be accommodated in the support portion 150, it is possible to provide a further enhanced stability. Although the protection circuit module 100 is used in a vibrating condition of, for example, a vehicle, it is possible to maintain a stable location of the protection circuit module 100 and to maintain a firm fastening/coupling state of the entire devices. In addition, since the support portion 150 surrounds the second cover 130 or the protection circuit module 100, it is possible to protect the second cover 130 or the protection circuit module 100 from an external impact. The configuration may be applied alike to the aforementioned embodiment in which the circuit case is configured. That is, the support portion 150 may have a shape corresponding to a bottom surface of the circuit case and may be designed in a shape to surround at least a portion of the circuit case.

Also, the battery module may further include the fixing member 140 to achieve the fastening force of the protection circuit module 100 and the support portion 150, more particularly, the fastening force of the first cover 120, the substrate 110, the second cover 130, and the support portion 150. The fixing member 140 may be designed to penetrate and thereby couple the first cover 120, the substrate 110, the second cover 130, and the support portion 150 at a time. The fixing member 140 may be configured simultaneously together with the coupler of the first cover 120 and the second cover 130, thereby further improving the firmness. That is, the second cover 130 may be fixably pressed between the first cover 120 and the support portion 150. The fixing member 140 may use, for example, a bolt and a nut. For example, the bolt 140 may fix the protection circuit module 100 to the support portion 150 by penetrating the first cover 120, the substrate 110, and the second cover 130 at a time, and by coupling with the nut provided on one side of the support portion 150. In this instance, an insulating layer may be formed on the support portion 150 and the nut may be formed on the insulating layer.

Also, according to the above configuration, the fixing member 140 may guide ascending and descending of the second cover 130 over the support portion 150. When the fixing member 140 having penetrated the protection circuit module 100 is coupled with the support portion 150, the fixing member 140 may descend the second cover 130, more particularly, the protection circuit module 100 and thereby accommodate and couple the second cover 130 in the support portion 150. On the contrary, when separating the second cover 130 from the support portion 150, the fixing member 140 may be decoupled from the support portion 150 and thereby ascend the second cover 130, which may lead to separating the protection circuit module 100 from the support portion 150.

Meanwhile, in addition to penetrating and thereby coupling the first cover 120, the substrate 110, the second cover 130, and the support portion 150, the fixing member 140 may directly couple the protection circuit module 100 to the battery module frame. Also, when a bolt is used for the fixing member 140, the fixing member 140 may electrically connect the circuit portion 112 and the cell signal output portion by penetrating and thereby coupling the first cover 120, the substrate 110, the second cover 130, and the support portion 150, and by at the same time, forming a contact point between the circuit portion 112 and the cell signal output portion. Through the above configuration, the protection circuit module 100 may slidably couple with the battery module frame.

When the fixing member 140 penetrates and thereby couples the respective members, only a single fixing member 140 may be provided and may penetrate the center of the respective members. For example, when a tab to be described below is provided, the fixing member 140 may penetrate the center of a tab arrangement. When a plurality of fixing members is used at locations instead of the center of each member, the fastening force may be out of balance. Accordingly, by making the fixing member 140 penetrate the center of and thereby couple the respective members, the balance may be maintained and the cell lead and/or the sensing module may be simultaneously connected with the connection terminal 111 at a time.

In addition, for the penetration of the fixing member 140, the fixing holes 125, 115, 135, and 150 may be formed on the first cover 120, the substrate 110, the second cover 130, and the support portion 150, respectively. A plurality of ribs may be provided on at least one of the fixing holes 125, 115, 135, and 150. A description related thereto will be made by referring again to FIG. 3. Referring to FIG. 3, the plurality of ribs 126 is formed in a radial form along the periphery of the fixing hole 125 formed on the first cover 120, thereby supporting the fixing member 140. Accordingly, it is possible to prevent the first cover 120 from being damaged due to the fastening force of the fixing member 140. Although the present embodiment describes that the plurality of ribs 126 is provided only to the fixing hole 125 of the first cover 120, it is only an example. Also, a supporting structure using the same method may be applied to the fixing hole 115 of the substrate 110, the fixing hole 135 of the second cover 130, the fixing hole 155 of the support portion 150.

Although not illustrated, the insulating layer may be formed between one end (a lower end in the present embodiment) of the fixing member 140 and the cell lead, and may secure an insulation distance. Accordingly, it is possible to prevent short from occurring due to discharge. For example, the insulating layer may be formed on the support portion 150. When the protection circuit module 100 is to be accommodated in or coupled with the support portion 150, the insulation distance may be secured by locating the lower end of the protection circuit module 100 on the insulating layer and by avoiding a direct contact with the cell lead. Further, the insulating layer may be formed using the same material as the support portion 150.

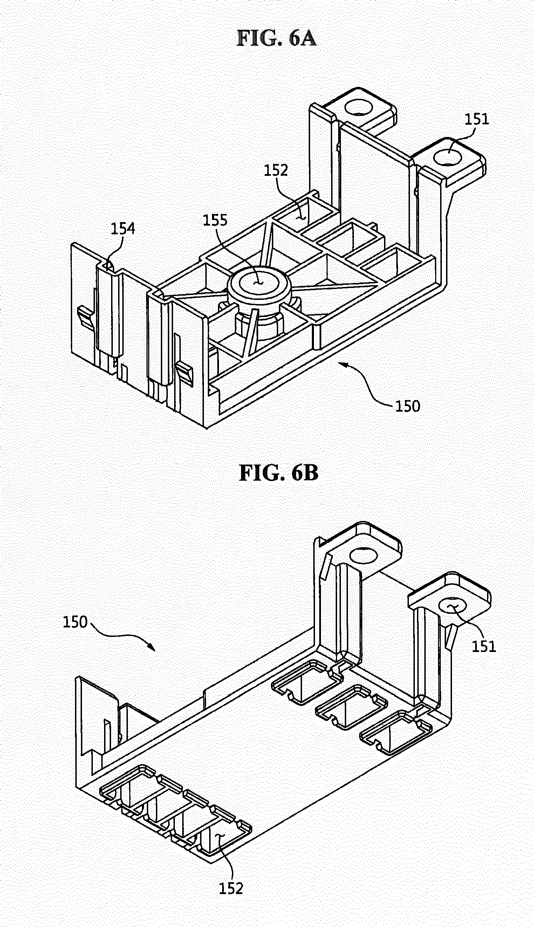

FIGS. 6A and 6B are perspective views of the support portion 150 according to an embodiment. The support portion 150 may be fixably coupled with the battery module frame through the fixing hole 151. A dented guide portion corresponding to a second guide portion 154 may be formed on one side of the support portion 150 to guide and thereby accommodate the protection circuit module 100 in the support portion 150. It will be described below. Further, the connection terminal hole 152 for exposing the connection terminal 111 may be formed to couple the connection terminal 111 of the protection circuit module 100 with the cell lead and/or the sensing module. A description related thereto will be made below.

FIGS. 7A and 7B are perspective views illustrating a state in which a battery module 200 is not assembled. Hereinafter, a description will be made based on a battery module in which cell leads are bi-directionally formed. However, a coupling method using a tab may be applied to a battery module in which cell leads are formed in the same direction, in addition to the battery module in which the cell leads are bi-directionally formed. Meanwhile, a description will be made based on an example in which the tab 165 is formed on a cell lead 160 and the tab 165 is coupled with the connection terminal 111. However, it is only an example and the tab may be formed on a bus-bar. For example, a separate bus-bar may be provided to the cell lead and cell lead lines may be attached to both sides of the bus-bar and the tab may be formed on one side of the bus-bar. The cell lead 160 disclosed herein may be considered as a concept of including the cell lead itself, and further, the cell lead and the bus-bar provided to the cell lead. Also, the tab 165 may be considered as a concept of including the tab formed on the cell lead and further, the tab formed on the bus-bar provided to the cell lead.

The cell lead 160 and/or the sensing module 170 may be provided to the battery module frame 1. As described above, the support portion 150 is fixably coupled with the battery module frame 1 through the fixing hole 151 and the protection circuit module 100 is accommodated in the support portion 150. In this instance, the fixing member 140 is provided to penetrate and thereby couple the protection circuit module 100 and the support portion 150.

The tabs 165 and/or 175 may be formed on the cell lead 160 and/or the sensing module 170, respectively. The tabs 165 and 175 may be coupled with the connection terminal 111 mounted on the substrate 110 of the protection circuit module 100 and may transmit an electrical signal of a cell to the connection terminal 111. According to the battery module 200 constructed as above, welding or soldering is not required and the battery module 200 may be readily assembled and separated using the tabs 165 and 175.

Further, according to a modified example, a tab may be separately provided on one side of a battery module frame and the tab or a cell lead may be coupled with the connection terminal 111.

A state in which the connection terminal 111 and the tabs 165 and 175 are coupled will be described with reference to FIGS. 4A, 4B, 6A, and 6B. As described above, the connection terminal protecting portion 131 for accommodating the connection terminal 111 may be formed on the second cover 130 of the protection circuit module 100, and the guide slot 132 for coupling the connection terminal 111 with the cell lead 160 and/or the sensing module 170 may be formed on the connection terminal protecting portion 131. The connection terminal hole 152 is formed on the support portion 150 at a location corresponding to the connection terminal 111. Thus, without exposing the connection terminal 111, the cell lead 160 and/or the sensing module 170 may be connected through the connection terminal hole 152. Here, the tab 165 of the cell lead 160 and/or the tab 175 of the sensing module 170 may be connected to the connection terminal 111 through slidable coupling and may transmit and receive an electrical signal.

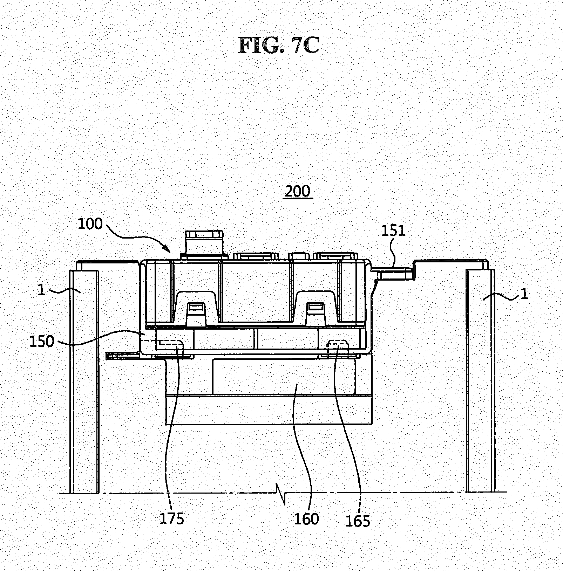

FIG. 7C is a front view illustrating a state in which assembly of the battery module 200 is completed. As described above, it can be seen from FIG. 7C that the tabs 165 and 175 of the cell lead 160 and/or the sensing module 170 are coupled with the connection terminal 111 of the protection circuit module 100. The above configuration, that is, a location of each blocked module may be firmly maintained and thus, it is possible to maintain the coupling strength under a harsh condition of, for example, a vehicle. In addition, a sensing signal may be stably transmitted to the BMS by preventing short-circuit of a contact point.

FIGS. 8A and 8B are perspective views illustrating a state in which the protection circuit module 100 and the support portion 150 are coupled. The protection circuit module 100 and the support portion 150 may be easily coupled through corresponding guide portions formed on the protection circuit module 100 and the support portion 150, respectively. For example, a first guide portion 124 may be formed on one side of the first cover 120 of the protection circuit module 100 and the second guide portion 154 in a shape corresponding thereto may be formed on one side of the support portion 150. That is, the protection circuit module 100 may be accommodated in the support portion 150 in such a manner that the first guide portion 124 is guided by the second guide portion 154. An assembling direction of the protection circuit module 100 or the circuit case may be easily identified through the first and second guide portions 124 and 154. Also, it is possible to improve the productivity by enhancing an assembly speed. When the assembly is completed, it is possible to improve the completeness and durability of assembly. Further, although the present embodiment describes that the first guide portion 124 is formed on the first cover 120, it is only an example. The first guide portion 124 may also be formed on one side of the second cover 130.

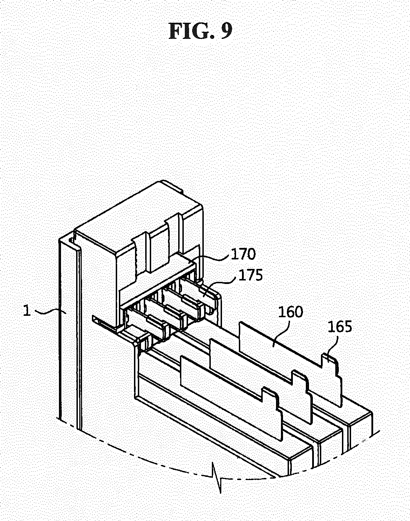

FIG. 9 is a perspective view illustrating the sensing module 170. The tab 175 is formed on the sensing module 170 and is connected to the protection circuit module 100. The sensing module 170 may be coupled with one side of the battery module frame 1. In this instance, the sensing module 170 may be slidably coupled with one side of the battery module frame 1. For example, a guide rail for the sensing module 170 may be provided to the battery module frame 1 and a protrusion may be provided to the sensing module 170 whereby the protrusion may be guided along the guide rail to thereby move the sensing module 170 up to a predetermined location. At the location, a coupling device such as a hook combinable with the protrusion may be provided and coupled with the protrusion. In this manner, the sensing module 170 may be fixed to the battery module frame 1. Although the present embodiment describes that the sensing module 170 is provided on one side of the battery module frame separately from the protection circuit module 100, it is only an example. The sensing module 170 may be provided on one side of the protection circuit module 100. For example, the sensing module 170 may be directly connected to one side of the protection circuit module 100 through the tab 175 without being connected to the battery module frame. Alternatively, the sensing module 170 may be mounted on the substrate in the protection circuit module 100.

The support portion 150 is described to couple with the battery module frame 1 through the fixing hole 151, however, is not limited thereto. That is, the support portion 150 and the battery module frame 1 may be integrally formed. In this case, compared to a case in which the support portion 150 is separately manufactured, it is possible to save manufacturing cost. An assembly process may be further simplified to thereby reduce a manufacturing time. In addition, since a coupling relationship is simplified, it is possible to enhance durability about an external condition such as vibration and abrasion.

## Claims

1. A protection circuit module (100) configured to protect a battery, the protection circuit module comprising:
a substrate (110);
a connection terminal (111) configured to mount on the substrate (110), and to receive an electrical signal of a cell from a cell lead (165) and/or a sensing module (170);
a circuit portion (112) configured to mount on the substrate (110);
a first cover (120) configured to cover one side of the substrate (110);
a second cover (130) configured to accommodate the substrate (110), and to cover the other side of the substrate (110); and
a data connector (113) configured to mount on the substrate (110),
**characterized in that**
the circuit portion (112) is configured to connect the cell lead (165) and/or the sensing module (170) and the connection terminal (111), wherein the circuit portion (112) comprises one of or a combination of at least two of a fuse, a relay, a breaker, and a switch;
a data connector inserting slot (123) for mounting the data connector (113) on the substrate (110) is formed on the first cover (120); and
a circuit portion inserting slot (122) for mounting the circuit portion (112) on the substrate (110) is formed on the first cover (120).

2. The protection circuit module of claim 1, wherein a coupler for mutual coupling is formed on the first cover (120) and second cover (130).

3. The protection circuit module of claim 1, further comprising:
a fixing member (140) configured to penetrate and thereby couple the first cover (120), the substrate (110), and the second cover (130) at a time.

4. The protection circuit module of claim 3, wherein the fixing member (140) is configured to penetrate the center of the first cover (120), the substrate (110), and the second cover (130).

5. The protection circuit module of claim 1, wherein a connection terminal protecting portion (131) for accommodating the connection terminal (111) to protect the connection terminal (111) is formed on the second cover (130).

6. The protection circuit module of claim 5, wherein a guide slot (132) for coupling the connection terminal (111) with the cell lead (165) and/or the sensing module (170) is formed on the connection terminal protecting portion (131).

7. The protection circuit module of claim 1, further comprising:
a support portion (150) of which one side couples with the second cover (130) and of which the outer side is detachable from a vehicle box.

8. The protection circuit module of claim 7, wherein the second cover (130) is configured to couple with the support portion (150) with ascending and descending over the support portion (150).

9. The protection circuit module of claim 8, further comprising:
a fixing member (140) configured to penetrate and thereby couple the first cover (120), the substrate (110), and the second cover (130) at a time, and to guide ascending and descending of the second cover (130) over the support portion (150).

10. The protection circuit module of claim 7, further comprising:
a first guide portion (124) formed on one side of the first cover (120) or the second cover (130); and
a second guide portion (154) formed on one side of the support portion (150), and configured to correspond to the first guide portion (124),
wherein coupling of the second cover (130) and the support portion (150) is guided by the first guide portion (124) and the second guide portion (154).

11. A protection circuit module of claim 7, wherein the second cover (130) is fixably pressed between the first cover (120) and support portion (150).

12. The protection circuit module of claim 11, further comprising:
a fixing member (140) configured to couple the first cover (120), the substrate (110), the second cover (130), and the support portion (150) at a time.

13. The protection circuit module of claim 7, further comprising:
an insulating layer formed on the support portion (150); and
a circuit case configured by a first cover (120) and a second cover (130), the circuit case configured to accommodate the substrate (110) therein,
wherein the one end of the fixing member (140) corresponding to a bottom surface of the circuit case is located on the insulating layer.

## Patentansprüche

1. Schutzschaltungsmodul (100), konfiguriert zum Schützen einer Batterie, wobei das Schutzschaltungsmodul Folgendes umfasst:
ein Substrat (110);
einen Verbindungsanschluss (111), konfiguriert zum Montieren an dem Substrat (110) und zum Empfangen eines elektrischen Signals einer Zelle von einer Zellleitung (165) und/oder einem Erfassungsmodul (170);
einen Schaltkreisabschnitt (112), konfiguriert zum Montieren an dem Substrat (110);
eine erste Abdeckung (120), konfiguriert zum Abdecken einer Seite des Substrats (110);
eine zweite Abdeckung (130), konfiguriert zum Aufnehmen des Substrats (110) und zum Abdecken der anderen Seite des Substrats (110); und
einen Datenverbinder (113), konfiguriert zum Montieren an dem Substrat (110),
**dadurch gekennzeichnet, dass**
der Schaltkreisabschnitt (112) zum Verbinden der Zellleitung (165) und/oder des Erfassungsmoduls (170) und des Verbindungsanschlusses (111) konfiguriert ist, wobei der Schaltkreisabschnitt (112) eines aus oder eine Kombination aus wenigstens zwei aus einer Sicherung, einem Relais, einem Unterbrecher und einem Schalter umfasst;
ein Datenverbindereinführungsschlitz (123) zum Montieren des Datenverbinders (113) an dem Substrat (110) an der ersten Abdeckung (120) ausgebildet ist; und
ein Schaltkreisabschnittseinführungsschlitz (122) zum Montieren des Schaltkreisabschnitts (112) an dem Substrat (110) an der ersten Abdeckung (120) ausgebildet ist.

2. Schutzschaltungsmodul nach Anspruch 1, wobei ein Koppler für eine gegenseitige Kopplung an der ersten Abdeckung (120) und der zweiten Abdeckung (130) ausgebildet ist.

3. Schutzschaltungsmodul nach Anspruch 1, das ferner Folgendes umfasst:
ein Befestigungselement (140), konfiguriert zum Penetrieren und dadurch Koppeln jeweils der ersten Abdeckung (120), des Substrats (110) und der zweiten Abdeckung (130).

4. Schutzschaltungsmodul nach Anspruch 3, wobei das Befestigungselement (140) zum Penetrieren der Mitte der ersten Abdeckung (120), des Substrats (110) und der zweiten Abdeckung (130) konfiguriert ist.

5. Schutzschaltungsmodul nach Anspruch 1, wobei ein Verbindungsanschlussschutzabschnitt (131) zum Aufnehmen des Verbindungsanschlusses (111) zum Schützen des Verbindungsanschlusses (111) an der zweiten Abdeckung (130) ausgebildet ist.

6. Schutzschaltungsmodul nach Anspruch 5, wobei ein Führungsschlitz (132) zum Koppeln des Verbindungsanschlusses (111) mit der Zellleitung (165) und/oder dem Erfassungsmodul (170) an dem Verbindungsanschlussschutzabschnitt (131) ausgebildet ist.

7. Schutzschaltungsmodul nach Anspruch 1, das ferner Folgendes umfasst:
einen Auflageabschnitt (150), von dem eine Seite mit der zweiten Abdeckung (130) gekoppelt wird und die andere Seite von einem Fahrzeugkasten abgenommen werden kann.

8. Schutzschaltungsmodul nach Anspruch 7, wobei die zweite Abdeckung (130) zum Koppeln mit dem Auflageabschnitt (150) mit Ansteigen und Abfallen über dem Auflageabschnitt (150) konfiguriert ist.

9. Schutzschaltungsmodul nach Anspruch 8, das ferner Folgendes umfasst:
ein Befestigungselement (140), konfiguriert zum Penetrieren und dadurch Koppeln jeweils der ersten Abdeckung (120), des Substrats (110) und der zweiten Abdeckung (130) und zum Führen des Ansteigens und Abfallens der zweiten Abdeckung (130) über dem Auflageabschnitt (150).

10. Schutzschaltungsmodul nach Anspruch 7, das ferner Folgendes umfasst:
einen ersten Führungsabschnitt (124), der auf einer Seite der ersten Abdeckung (120) oder der zweiten Abdeckung (130) ausgebildet ist, und
einen zweiten Führungsabschnitt (154), der auf einer Seite des Auflageabschnitts (150) ausgebildet und so konfiguriert ist, dass er dem ersten Führungsabschnitt (124) entspricht,
wobei das Koppeln der zweiten Abdeckung (130) und des Auflageabschnitts (150) vom ersten Führungsabschnitt (124) und vom zweiten Führungsabschnitt (154) geführt wird.

11. Schutzschaltungsmodul nach Anspruch 7, wobei die zweite Abdeckung (130) fixierbar zwischen die erste Abdeckung (120) und den Auflageabschnitt (150) gepresst wird.

12. Schutzschaltungsmodul nach Anspruch 11, das ferner Folgendes umfasst:
ein Befestigungselement (140), konfiguriert zum Koppeln jeweils der ersten Abdeckung (120), des Substrats (110), der zweiten Abdeckung (130) und des Auflageabschnitts (150).

13. Schutzschaltungsmodul nach Anspruch 7, das ferner Folgendes umfasst:
eine auf dem Auflageabschnitt (150) ausgebildete Isolierschicht; und
ein Schaltungsgehäuse, konfiguriert von einer ersten Abdeckung (120) und einer zweiten Abdeckung (130), wobei das Schaltungsgehäuse so konfiguriert ist, dass es das Substrat (110) darin aufnimmt,
wobei sich das eine Ende des Befestigungselements (140) entsprechend einer Bodenfläche des Schaltungsgehäuses auf der Isolierschicht befindet.

## Revendications

1. Module de circuit de protection (100) configuré pour protéger une batterie, le module de circuit de protection comprenant :
un substrat (110) ;
une borne de connexion (111) configurée pour être montée sur le substrat (110), et recevoir un signal électrique d'une cellule depuis une broche de cellule et/ou un module de détection (170) ;
une partie de circuit (112) configurée pour être montée sur le substrat (110) ;
un premier couvercle (120) configuré pour couvrir un coté du substrat (110) ;
un second couvercle (130) configuré pour recevoir le substrat (110), et couvrir l'autre côté du substrat (110) ; et
un connecteur de données (113) configuré pour être monté sur le substrat (110),
**caractérisé en ce que**
la partie de circuit (112) est configurée pour connecter la broche de cellule (165) et/ou le module de détection (170) et la borne de connexion (111), dans lequel la partie de circuit (112) comprend l'un d'un fusible, d'un relais, d'un disjoncteur et d'un commutateur ou d'une combinaison d'au moins deux d'un fusible, d'un relais, d'un disjoncteur et d'un commutateur ;
une fente d'insertion de connecteur de données (123) pour monter le connecteur de données (113) sur le substrat (110) est formée sur le premier couvercle (120) ; et
une fente d'insertion de partie de circuit (122) pour monter la partie de circuit (112) sur le substrat (110) est formée sur le premier couvercle (120).

2. Module de circuit de protection selon la revendication 1, dans lequel un coupleur destiné à un couplage mutuel est formé sur le premier couvercle (120) et le second couvercle (130).

3. Module de circuit de protection selon la revendication 1, comprenant en outre :
un élément de fixation (140) configuré pour pénétrer dans le premier couvercle (120), le substrat (110), et le second couvercle (130) à la fois et ainsi les coupler.

4. Module de circuit de protection selon la revendication 3, dans lequel l'élément de fixation (140) est configuré pour pénétrer dans le centre du premier couvercle (120), du substrat (110), et du second couvercle (130).

5. Module de circuit de protection selon la revendication 1, dans lequel une partie de protection de borne de connexion (131) destinée à recevoir la borne de connexion (111) pour protéger la borne de connexion (111) est formée sur le second couvercle (130).

6. Module de circuit de protection selon la revendication 5, dans lequel une fente de guidage (132) destinée au couplage de la borne de connexion (111) avec la broche de cellule (165) et/ou le module de détection (170) est formée sur la partie de protection de borne de connexion (131).

7. Module de circuit de protection selon la revendication 1, comprenant en outre :
une partie de support (150) dont un côté est couplé au second couvercle (130) et dont l'autre côté est détachable d'un boîtier de véhicule.

8. Module de circuit de protection selon la revendication 7, dans lequel le second couvercle (130) est configuré pour se coupler à la partie de support (150) par montée et descente sur la partie de support (150).

9. Module de circuit de protection selon la revendication 8, comprenant en outre :
un élément de fixation (140) configuré pour pénétrer dans le premier couvercle (120), le substrat (110), et le second couvercle (130) à la fois et ainsi les coupler, et guider la montée et la descente du second couvercle (130) sur la partie de support (150).

10. Module de circuit de protection selon la revendication 7, comprenant en outre :
une première partie de guidage (124) formée sur un côté du premier couvercle (120) ou du second couvercle (130) ; et
une seconde partie de guidage (154) formée sur un côté de la partie de support (150), et configurée pour correspondre avec la première partie de guidage (124),
dans lequel le couplage du second couvercle (130) et de la partie de support (150) est guidé par la première partie de guidage (124) et la seconde partie de guidage (154).

11. Module de circuit de protection selon la revendication 7, dans lequel le second couvercle (130) est pressé de manière fixe entre le premier couvercle (120) et la partie de support (150).

12. Module de circuit de protection selon la revendication 11, comprenant en outre :
un élément de fixation (140) configuré pour coupler le premier couvercle (120), le substrat (110), le second couvercle (130) et la partie de support (150) à la fois.

13. Module de circuit de protection selon la revendication 7, comprenant en outre :
une couche isolante formée sur la partie de support (150) ; et
un boîtier de circuit configuré par un premier couvercle (120) et un second couvercle (130), le boîtier de circuit étant configuré pour renfermer le substrat (110) ;
dans lequel l'extrémité de l'élément de fixation (140) correspondant à une surface inférieure du boîtier de circuit est située sur la couche isolante.
